# EUROPEAN PATENT APPLICATION

(11) **EP 4 148 800 A1**
(43) Date of publication of application: **15.03.2023**
(21) Application number: 21758036.4
(22) Date of filing: 08.02.2021
(51) Int. Cl.: H01L 27/32

(54) **DISPLAY SUBSTRATE, DISPLAY PANEL, DISPLAY DEVICE AND METHOD FOR MANUFACTURING DISPLAY SUBSTRATE**

(30) Priority: 09.05.2020 WO PCT/CN2020/089413
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: HOU, Rui, Beijing 100176 (CN); WANG, Yulin, Beijing 100176 (CN); YANG, Ming, Beijing 100176 (CN); LAI, Weilin, Beijing 100176 (CN); DU, Yide, Beijing 100176 (CN); BAO, Jiandong, Beijing 100176 (CN)
(74) Representative: Isarpatent
(86) International application number: PCT/CN2021/076057
(87) International publication number: WO 2021/227581

(57) **Abstract**

The present disclosure provides a display substrate, a display panel, a display device, and a method for manufacturing the display substrate. A display region includes: a first display region including a first thin film encapsulation structure; a second display region including a second thin film encapsulation structure; and a transition display region including a third thin film encapsulation structure. The first thin film encapsulation structure includes a first inorganic encapsulation layer, a first organic encapsulation layer and a second inorganic encapsulation layer. The second thin film encapsulation structure includes the first organic encapsulation layer, the second inorganic encapsulation layer and a second organic encapsulation layer. The third thin film encapsulation structure includes a first portion and a second portion. The first portion includes the first inorganic encapsulation layer, the first organic encapsulation layer, the second inorganic encapsulation layer and the second organic encapsulation layer. The second portion includes the first inorganic encapsulation layer, the second inorganic encapsulation layer and the second organic encapsulation layer. According to the display substrate, the display panel, the display device and the method for manufacturing the display substrate in the present disclosure, it is able to improve a user's visual experience.

## Description

### CROSS-REFERENCE TO RELATED APPLICATION

The present application claims a priority of the PCT application No. PCT/CN2020/089413 filed on May 9, 2020, which is incorporated herein by reference in its entirety.

### TECHNICAL FIELD

The present disclosure relates to the field of display technology, in particular to a display substrate, a display panel, a display device, and a method for manufacturing the display substrate.

### BACKGROUND

Organic Light-Emitting Diode (OLED) has an organic compound film capable of emitting light in response to a current, and an organic material is sandwiched between two electrodes, at least one of which is a transparent electrode. The OLED has excellent luminous performance and luminous efficiency, and its driving voltage is relatively low, so it is a good candidate for a display screen.

### SUMMARY

An object of the present disclosure is to provide a display substrate, a display panel, a display device, and a method for manufacturing the display substrate, so as to improve visual experience of a user.

The technical solutions of the present disclosure will be described as follows.

In one aspect, the present disclosure provides in some embodiments a display substrate, including a display region. The display region includes: a first display region including a plurality of display units arranged on a substrate and a first thin film encapsulation structure arranged at a light-emitting side of the plurality of display units; a second display region including a plurality of display units arranged on the substrate and a second thin film encapsulation structure arranged at a light-emitting side of the plurality of display units; and a transition display region including a plurality of display units arranged on the substrate and a third thin film encapsulation structure arranged at a light-emitting side of the plurality of display units, the transition display region being located between the first display region and the second display region. The first thin film encapsulation structure includes a first inorganic encapsulation layer, a first organic encapsulation layer and a second inorganic encapsulation layer laminated one on another at the light-emitting side of the plurality of display units. The second thin film encapsulation structure includes the first inorganic encapsulation layer, the second inorganic encapsulation layer and a second organic encapsulation layer laminated one on another at the light-emitting side of the plurality of display units. The third thin film encapsulation structure includes a first portion arranged at a side adjacent to the first display region and a second portion arranged at a side adjacent to the second display region, the first portion includes the first inorganic encapsulation layer, the first organic encapsulation layer, the second inorganic encapsulation layer and the second organic encapsulation layer laminated one on another at the light-emitting side of the plurality of display units, and the second portion includes the first inorganic encapsulation layer, the second inorganic encapsulation layer and the second organic encapsulation layer laminated one on another at the light-emitting side of the plurality of display units.

In a possible embodiment of the present disclosure, the second organic encapsulation layer has a light transmittance greater than the first organic encapsulation layer.

In a possible embodiment of the present disclosure, the display region includes a plurality of sides, adjacent sides in the plurality of sides cross to define a plurality of corner portions, and the second display region is located at at least one of the plurality of corner portions.

In a possible embodiment of the present disclosure, a first barrier is arranged between the first display region and the transition display region, and a second barrier is arranged between the second display region and the transition display region.

In a possible embodiment of the present disclosure, a first barrier and a second barrier are arranged at the transition display region, orthogonal projections of the first barrier and the second barrier onto the substrate do not coincide with an orthogonal projection of each display unit at the transition display region onto the substrate, the first barrier is arranged at a side of the transition display region adjacent to the first display region, and the second barrier is arranged at a side of the transition display region adjacent to the second display region.

In a possible embodiment of the present disclosure, the first inorganic encapsulation layer, the first organic encapsulation layer and the second inorganic encapsulation layer of the first portion are formed by extending the first thin film encapsulation structure to a side where the transition display region is located, the first inorganic encapsulation layer, the first organic encapsulation layer and the second inorganic encapsulation layer of the first portion cover the first barrier, the second portion is formed by extending the second thin film encapsulation structure to a side where the transition display region is located and covers the second barrier, and the second organic encapsulation layer of the first portion is formed by extending the second organic encapsulation layer of the second portion to a side where the transition display region is located.

In a possible embodiment of the present disclosure, the first organic encapsulation layer of the first portion is provided with a slope surface at a side adjacent to the second display region, and the second organic encapsulation layer of the first portion covers a side of the slope surface away from the substrate.

In a possible embodiment of the present disclosure, the second organic encapsulation layer of the second thin film encapsulation structure is substantially flush with a surface of the second organic encapsulation layer of the third thin film encapsulation structure away from the substrate.

In a possible embodiment of the present disclosure, the first display region has a first pixel density, the second display region has a second pixel density, the transition display region has a third pixel density, and each of the second pixel density and the third pixel density is smaller than or equal to the first pixel density.

In a possible embodiment of the present disclosure, the second display region includes: a stretchable substrate, a plurality of opening patterns being distributed on a surface of the stretchable substrate, each opening pattern in the plurality of opening patterns including a plurality of first openings, a plurality of bridge regions being formed between at least a part of adjacent first openings in the plurality of first openings in such a manner as to surround an island region, the plurality of second display units being arranged on the island regions formed by the opening patterns; and a plurality of wiring units each coupled between the display units on each island region and arranged at a corresponding bridge region.

In a possible embodiment of the present disclosure, at least one of the plurality of display units includes: a first planarization layer arranged at a front side of the substrate along a light-emitting direction of the display substrate; an organic insulation layer arranged at a side of the first planarization layer away from the substrate; and a first electrode layer arranged at a side of the first planarization layer away from the substrate. The first barrier includes a first groove, the first groove is formed in the first planarization layer and the organic insulation layer covers the first groove in a shape-following manner, or the first groove is formed in the organic insulation layer. The second barrier includes a second groove, the second groove is formed in the first planarization layer and the organic insulation layer covers the second groove in a shape-following manner, or the second groove is formed in the organic insulation layer. The first inorganic encapsulation layer is arranged at a side of the first electrode layer away from the substrate and covers the first electrode layer. The first organic encapsulation layer covers a part of the first inorganic encapsulation layer at a side of the first groove away from the second groove, a part of the first inorganic encapsulation layer at the first groove, and a part of the first inorganic encapsulation layer between the first groove and the second groove and adjacent to the first groove, and does not cover a part of the first inorganic encapsulation layer between the first groove and the second groove and adjacent to the second groove, a part of the first inorganic encapsulation layer at the second groove, and a part of the first inorganic encapsulation layer at a side of the second groove away from the first groove. The second inorganic encapsulation layer covers the first organic encapsulation layer and a part of the first inorganic encapsulation layer not covered by the first organic encapsulation layer. The second organic encapsulation layer covers a part of the second inorganic encapsulation layer at the first groove and a part of the second inorganic encapsulation layer at a side of the first groove away from the first display region, and does not over the first openings.

In a possible embodiment of the present disclosure, the organic insulation layer includes a first post spacer arranged at the first display region, a second post spacer arranged at the transition display region, and a third post spacer arranged at the second display region, the first groove is formed in the first post spacer, and the second groove is formed in the second post spacer.

In a possible embodiment of the present disclosure, each of the first groove and the second groove includes a continuous groove extending in a first direction, and the first direction is an extension direction of a boundary between the first display region and the transition display region.

In a possible embodiment of the present disclosure, the continuous groove has a groove width of about 5µm to 15µm in a second direction and a groove height of about 1.5µm to 2.5µm in a third direction, the second direction is perpendicular to the first direction and parallel to the stretchable substrate, and the third direction is perpendicular to the stretchable substrate.

In a possible embodiment of the present disclosure, the first groove and/or the second groove include a least one column of discrete grooves arranged sequentially in a second direction, the second direction is perpendicular to the first direction and parallel to the stretchable substrate, and each column of discrete grooves includes a plurality of discrete grooves spaced apart from each other in the first direction.

In a possible embodiment of the present disclosure, the at least one column of discrete grooves includes a plurality of columns of discrete grooves, and adjacent columns of discrete grooves are spaced apart from each other by about 2µm to 15µm.

In a possible embodiment of the present disclosure, at least one of the plurality of display units further includes a first isolation structure arranged between the second groove and the first opening and configured to interrupt the first electrode layer at both sides of the first isolation structure. The first electrode layer covers the first isolation structure, and is arranged at a side of the first isolation structure adjacent to the second groove and a side of the first isolation structure adjacent to the first opening.

In a possible embodiment of the present disclosure, at least one of the plurality of display units at the second display region further includes a first passivation layer, a part of the first passivation layer is arranged between the organic insulation layer at the second display region and the first opening, and at least a part of the first passivation layer is arranged at a side of the first planarization layer away from the stretchable substrate. The first isolation structure includes at least one third groove arranged between the first passivation layer and the first planarization layer, and the first electrode layer covering a bottom of the at least one third groove is separated from the first electrode layer covering the first passivation layer.

In a possible embodiment of the present disclosure, at least one of the plurality of display units at the second display region further includes a second passivation layer, and at least a part of the second passivation layer is arranged at a side of the first planarization layer adjacent to the stretchable substrate. The first passivation layer includes a first portion arranged at a side of the first planarization layer away from the stretchable substrate and a second portion at a side of the first planarization layer adjacent to the first opening, the second portion covers a surface of the first planarization layer adjacent to the first opening, and the second portion is coupled to a surface of the second passivation layer so that the first passivation layer protects a surface of the first planarization layer adjacent to the first opening in an isolated manner.

In a possible embodiment of the present disclosure, at least one of the plurality of display units at the second display region further includes an interlayer insulation layer arranged at the front side of the stretchable substrate along the light-emitting direction of the display substrate. The first isolation structure includes at least one first protrusion arranged at a surface of the interlayer insulation layer away from the stretchable substrate, the first electrode layer covers a top of the at least one first protrusion and a part of the surface of the interlayer insulation layer, and the first electrode layer at the top of the at least one first protrusion is separated from the first electrode layer at the surface of the interlayer insulation layer.

In a possible embodiment of the present disclosure, at least one of the plurality of wiring units includes: a second planarization layer arranged at the front side of the stretchable substrate along the light-emitting direction of the display substrate; a pixel definition layer arranged at a side of the second planarization layer away from the stretchable substrate, covering a part of a surface of the second planarization layer, and having at least one fourth groove; and a third electrode layer covering a bottom of the at least one fourth groove and a surface of the pixel definition layer. The third electrode layer covering the bottom of the at least one fourth groove is separated from the third electrode layer covering the surface of the pixel definition layer.

In a possible embodiment of the present disclosure, the quantity of third grooves in the at least one third groove is the same as the quantity of fourth grooves in the at least one fourth groove, and the at least one fourth groove is connected to the at least one third groove to form a closed loop surrounding the first opening.

In a possible embodiment of the present disclosure, at least one of the plurality of wiring units includes: a gate insulation layer arranged at the front side of the stretchable substrate along the light-emitting direction of the display substrate; at least one second protrusion arranged at a surface of the gate insulation layer away from the stretchable substrate; and a third electrode layer covering a top of the at least one second protrusion and a surface of the gate insulation layer not covered by the at least one second protrusion. The third electrode layer covering the top of the at least one second protrusion is separated from the third electrode layer covering the surface of the agate insulation layer.

In a possible embodiment of the present disclosure, the quantity of second protrusions in the at least one second protrusion is the same as the quantity of first protrusions in the at least one first protrusion, and the at least one second protrusion is connected to the at least one first protrusion to form a closed loop surrounding the first opening.

In a possible embodiment of the present disclosure, the first opening includes an open end arranged at a side away from the substrate, a bottom end arranged at a side adjacent to the substrate, and an opening body portion arranged between the open end and the bottom end. An opening width of at least one of the plurality of first openings is arranged in such a manner that an opening width of the opening body portion gradually increases along the light-emitting direction of the display substrate, an opening width of the open end is smaller than a maximum opening width of the opening body portion, and the maximum opening width of the opening body portion is greater than an opening width of the bottom end.

In a possible embodiment of the present disclosure, at least a part of a side wall of the opening body portion adjacent to the open end is of an arc-like shape.

In another aspect, the present disclosure provides in some embodiments a display panel, including the above-mentioned display substrate, and a cover plate arranged at a light-exiting side of the display substrate and encapsulated together with the display substrate.

In yet another aspect, the present disclosure provides in some embodiments a display device, including the above-mentioned display panel.

In still yet another aspect, the present disclosure provides in some embodiments a method for manufacturing a display substrate, including: providing a substrate; and forming a display region on the substrate. The display region includes: a first display region including a plurality of display units arranged on a substrate and a first thin film encapsulation structure arranged at a light-emitting side of the plurality of display units; a second display region including a plurality of display units arranged on the substrate and a second thin film encapsulation structure arranged at a light-emitting side of the plurality of display units; and a transition display region including a plurality of display units arranged on the substrate and a third thin film encapsulation structure arranged at a light-emitting side of the plurality of display units, the transition display region being located between the first display region and the second display region. The first thin film encapsulation structure includes a first inorganic encapsulation layer, a first organic encapsulation layer and a second inorganic encapsulation layer laminated one on another at the light-emitting side of the plurality of display units. The second thin film encapsulation structure includes the first inorganic encapsulation layer, the second inorganic encapsulation layer and a second organic encapsulation layer laminated one on another at the light-emitting side of the plurality of display units. The third thin film encapsulation structure includes a first portion arranged at a side adjacent to the first display region and a second portion arranged at a side adjacent to the second display region, the first portion includes the first inorganic encapsulation layer, the first organic encapsulation layer, and the second inorganic encapsulation layer laminated one on another at the light-emitting side of the plurality of display units, and the second portion includes the first inorganic encapsulation layer, the second inorganic encapsulation layer and the second organic encapsulation layer laminated one on another at the light-emitting side of the plurality of display units.

In a possible embodiment of the present disclosure, the forming the display region on the substrate includes: forming a first barrier and a second barrier at the display region; forming the first inorganic encapsulation layer at the display region; printing a first organic material on the first inorganic encapsulation layer to form a first organic material layer, a part of the first organic material layer being located at the first display region, and the other part of the first organic material extending to cover the first barrier and/or the second barrier; thinning the first organic material layer to remove a part of the first organic material layer and form the first organic encapsulation layer, so as to expose at least a part of the first inorganic encapsulation layer at the transition display region; forming the second inorganic encapsulation layer, a part of the second inorganic encapsulation layer covering the first organic encapsulation layer, the other part of the second inorganic encapsulation layer covering a part of the first inorganic encapsulation layer not covered by the first organic encapsulation layer; and coating the second organic encapsulation layer on the second inorganic encapsulation layer, a part of the second organic encapsulation layer covering a part of the second inorganic encapsulation layer covering the first organic encapsulation layer, and the other part covering a part of the first inorganic encapsulation layer not covered by the first organic encapsulation layer.

The present disclosure has the following beneficial effect.

According to the display substrate, the display panel, the display device and the method for manufacturing the display substrate in the embodiments of the present disclosure, the thin film encapsulation layers at different regions of the display region have different structures, so it is able to ensure the luminous efficiency at different regions of the display region as well as a service life, and improve a visual experience of a user.

### BRIEF DESCRIPTION OF THE DRAWINGS

The drawings constituting a part of the specification are used to describe the embodiments of the present disclosure, and these drawings and the specification are used together for explaining the principle of the present disclosure.

The present disclosure will become more apparent with reference to the drawings in conjunction with the following description. In these drawings,
Fig.1 is a schematic view showing a display panel according to one embodiment of the present disclosure;
Fig.2 is a schematic view showing the layout of a display substrate in the display panel according to one embodiment of the present disclosure;
Fig.3 is a topical top view of a first display region, a second display region and a transition display region in the display panel according to one embodiment of the present disclosure;
Fig.4 is a schematic view showing the display panel where a part of the display substrate corresponding to the second display region is formed on a glass substrate according to one embodiment of the present disclosure;
Fig.5 is a schematic view showing the display panel where the part of the display substrate corresponding to the second display region is removed from the glass substrate according to one embodiment of the present disclosure;
Fig.6 is a schematic view showing the display panel where a part of the display substrate corresponding to the first display region, the second display region and the transition display region is formed on the glass substrate according to one embodiment of the present disclosure;
Fig.7 is another schematic view showing the display panel where the part of the display substrate corresponding to the first display region, the second display region and the transition display region is formed on the glass substrate according to one embodiment of the present disclosure;
Fig.8 is a schematic view showing the arrangement of an island region, a first opening and a bridge region in the display panel according to one embodiment of the present disclosure;
Figs.9 and 10 are schematic views showing the arrangement of the island region, the first opening and the bridge region in the display panel according to one embodiment of the present disclosure;
Figs. 11 and 12 are sectional views of a first groove in the display panel according to one embodiment of the present disclosure; and
Figs. 13 to 16 are schematic views showing some steps of a method for manufacturing the display panel according to one embodiment of the present disclosure.

It should be appreciated that, each component in the drawings is not drawn in accordance with an actual scale. In addition, any identical or similar reference numeral represents an identical or similar element or element.

### DETAILED DESCRIPTION

The present disclosure will be described hereinafter in details with reference to the embodiments in conjunction with the drawings. The following embodiments are for illustrative purposes only, but shall not be construed as limiting the application or use of the present disclosure. The present disclosure may be implemented in various forms, but not limited to the embodiments provided herein. These embodiments are provided so as to facilitate the understanding of the present disclosure in a thorough and complete manner, and present the scope of the present disclosure to a person skilled in the art. It should be appreciated that, unless otherwise defined, the arrangement of components and steps, material constituents, numeric expressions and numeric values in these embodiments are for illustrative purposes only, but shall not be construed as liming the scope of the present disclosure.

Such words as "first" and "second" are merely used to differentiate different components rather than to represent any order, number or importance. Such words as "include" or "including" intends to indicate that an element before the word contains an element after the word, without excluding any other element. Such words as "on", "under", "left" and "right" are merely used to represent relative position relationship, and when an absolute position of the object is changed, the relative position relationship will be changed too.

In the present disclosure, when it is described that a specific element is arranged between a first element and a second element, there is, or there is not, an intermediate element between the specific element and the first or second element. When it is described that a specific element is coupled to the other element, it is directly coupled to the other element without any intermediate element, or it is indirectly coupled to the other element via an intermediate element.

Unless otherwise defined, any technical or scientific term used herein shall have the common meaning understood by a person skilled in the art. It should be further appreciated that, any term defined in a commonly-used dictionary shall be understood as having the meaning in conformity with that in the related art, and shall not be interpreted idealistically or extremely, unless clearly defined.

In the present disclosure, the word "about" refers to that a numerical range and/or numerical value is substantially identical to the list numerical range and/or numerical value in the case of an allowed process error and an allowed measurement error.

Any techniques, methods and devices known to a person skilled in the art will not be particularly discussed, and in an appropriate case, these techniques, methods and devices shall be considered as a part of the specification.

In the related art, a protection cover plate made of a high-molecular material is used to prevent an OLED flexible display device from being easily broken. It is found through research that, there is such a phenomenon as black edge at each of four corners of some OLED flexible display devices, and thereby a visual experience of a user is adversely affected. A display region is provided at each corner of a display panel to prevent the occurrence of the black edge, thereby to improve the visual experience of the user. However, there is a light-emission difference between a normal display region and the display region at each corner, so mixed colors visible to human eyes easily occur.

An object of the present disclosure is to provide a display substrate, a display panel, a display device, and a method for manufacturing the display substrate, so as to improve the visual experience of the user.

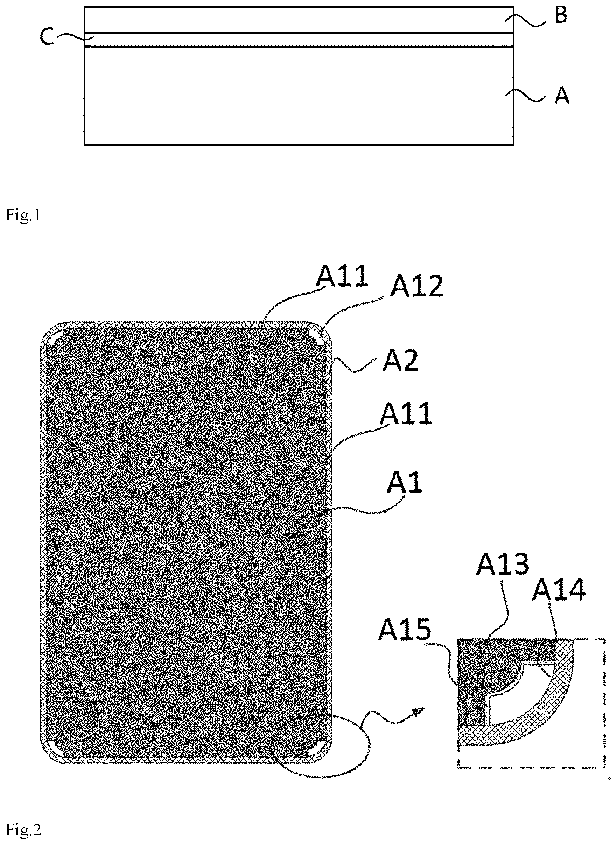

Fig. 1 is a schematic view showing a display substrate according to one embodiment of the present disclosure, and Fig.2 is a schematic view showing the layout of a display substrate in the display panel in Fig.1.

As shown in Figs.1 and 2, in some embodiments of the present disclosure, the display panel includes a display substrate A and a cover plate B. The cover plate B is arranged at a front side of the display substrate A along a light-exiting direction of the display substrate A, i.e., at a light-emitting side of the display substrate A. The display substrate A and the cover plate B are encapsulated through an encapsulation adhesive C (e.g., an Optically Clear Adhesive (OCA)). In Fig.2, the display substrate A includes a display region A1 and a non-display region A2 surrounding the display region A1. The display substrate A and the cover plate B are encapsulated at the non-display region A2. The cover plate B is made of a rigid or flexible material, e.g., glass or a Colorless Polyimide (CPI) thin film.

Referring to Fig.2, the display region A1 includes a plurality of sides A11, and adjacent sides A11 in the plurality of sides A11 cross to define a plurality of corner portions A12. In Fig.2, the display region A1 includes two groups of opposite sides A11, and the adjacent sides A11 are perpendicular to each other. Correspondingly, the display region A has four corner portions A12. The display region A1 includes a first display region A13, a second display region A14, and a transition region A15 between the first display region A13 and the second display region A14. The first display region A13 has a first pixel density, the second display region A14 has a second pixel density, and the transition region A15 has a third pixel density. The second pixel density is smaller than the first pixel density, and the third pixel density is equal to the firs pixel density or the second pixel density or between the first pixel density and the second pixel density. Here, the pixel density refers to the quantity of pixels in unit area.

Referring to Fig.2, in some embodiments of the present disclosure, the second display region A14 is arranged at at least one of the plurality of corner portions A12. In Fig.2, the second display region A14 is arranged at each corner portion A12. Considering that a black edge occurs at the corner portion in the related art when organic ink is filled between the corner portion of the display substrate and the cover plate for encapsulation, in the embodiments of the present disclosure, the second display region where the pixel density is lower than the pixel density at the first display region is arranged at the corner portion. In this way, on one hand, it is able to display an image at the corner portion, increase a screen-to-body ratio and reduce a width of a bezel, thereby to improve a visual experience of a user. On the other hand, it is able to reduce a difficulty in a machining process of the corner portion.

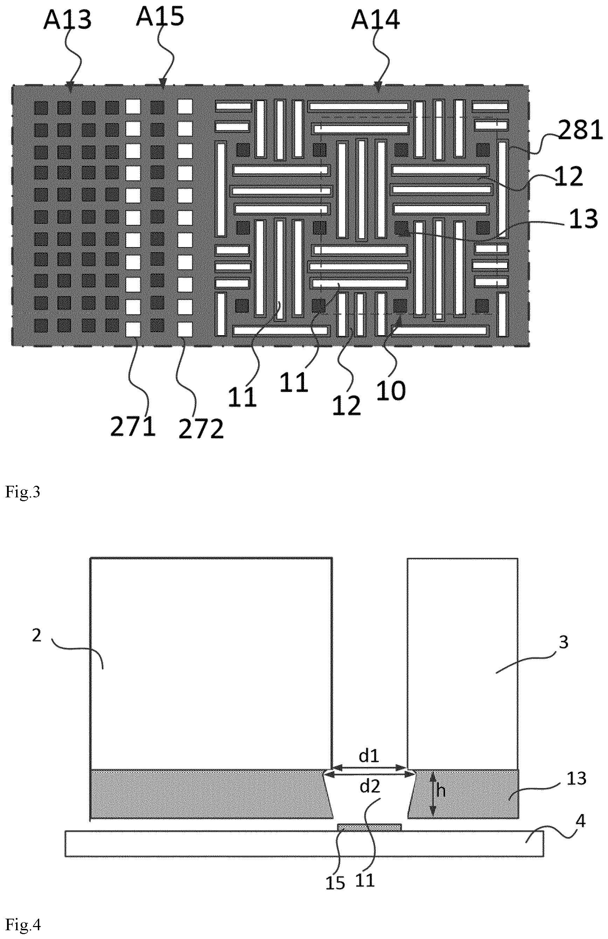

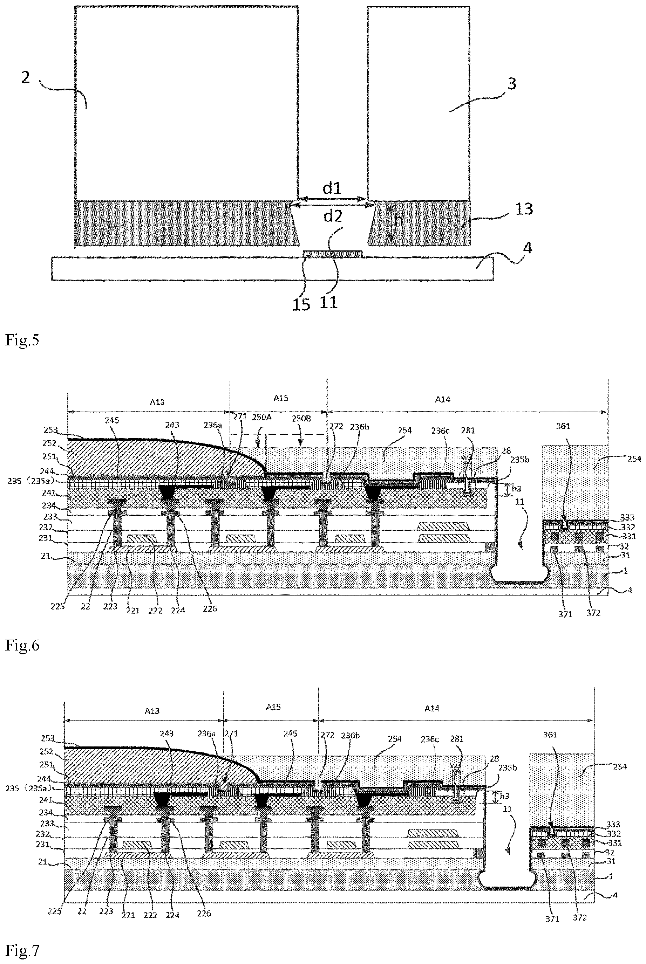

Fig.3 is a topical top view of the display panel according to one embodiment of the present disclosure, Fig.4 is a schematic view showing the display panel where a part of the display substrate corresponding to the second display region is formed on a glass substrate, and Fig.5 is a schematic view showing the display panel where the part of the display substrate corresponding to the second display region is removed from the glass substrate.

Referring to Figs.3 to 5, in some embodiments of the present disclosure, the second display region A14 includes a stretchable substrate 1, a plurality of display units 2 and a plurality of wiring units 3. The stretchable substrate 1 is made of a flexible material, e.g., Polyimide (PI). Referring to Fig.3, the stretchable substrate 1 includes a plurality of opening patterns 10 distributed on a surface of the stretchable substrate 1 (e.g., the opening patterns each consisting of a plurality of openings in a dotted box in Fig.3). Each opening pattern 10 in the plurality of opening patterns 10 includes a plurality of first openings 11, and a plurality of bridge regions 12 is formed between at least part of adjacent first openings 11 in the plurality of first openings 11 in such a manner as to surround an island region 13. Through the plurality of opening patterns 10 on the stretchable substrate 1, it is able to display an image at the second display region A14 in a stretched manner. When an image is displayed at the second display region in a stretched manner, the corner portion at the display region of the display substrate is more closely attached to the cover plate, so it is able to reduce or prevent the attachment of the corner portion to the cover plate from being adversely affected by such circumstances as bubbles during the encapsulation.

In Fig.3, three first openings 11 are arranged at each side of each island region 13 of the opening pattern 10, and two bridge regions 12 are formed between adjacent first openings 11 of the three first openings 11. In some other embodiments of the present disclosure, a position of each first opening 11 relative to the island region 13 as well as the quantity of the first openings 11 surrounding the island region 13 shall not be limited to those shown in Fig.3. Each first opening 11 has a width of about 15µm to 25µm. Referring to Fig.4, in some embodiments of the present disclosure, the display units 2 are arranged on the island regions 13 formed by the opening patterns 10 respectively. Each of the plurality of wiring units 3 is coupled between the display units 2 and arranged at a corresponding bridge region 12. Each display unit 2 has display subpixels (e.g., RGB subpixels) and a driving circuit, so as to display an image. The plurality of display units 2 is coupled to each other via the plurality of wiring units 3.

In order to enable the display units at each display region to emit light normally and prevent the occurrence of a material failure and electrode corrosion, each display region is encapsulated and protected through thin film encapsulation layers. The first display region A13 includes a plurality of display units arranged on a substrate and a first thin film encapsulation structure arranged at a light-emitting side of the plurality of display units. The second display region A13 includes a plurality of display units arranged on the substrate and a second thin film encapsulation structure arranged at a light-emitting side of the plurality of display units. The transition display region A15 includes a plurality of display units arranged on the substrate and a third thin film encapsulation structure arranged at a light-emitting side of the plurality of display units.

In the related art, usually the thin film encapsulation layers on the display substrate is a lamination structure including a first organic encapsulation layer, an organic encapsulation layer and a second inorganic encapsulation layer laminated one on another at the light-emitting side of the display units. The first inorganic encapsulation and the second inorganic encapsulation layer are each formed through Plasma Enhanced Chemical Vapor Deposition (PECVD), and the organic encapsulation layer is formed through printing. In order to prevent a risk of water and oxygen erosion to the display units at the second display region A14 when the organic material (e.g., organic ink) for printing the organic encapsulation layer overflows to the first opening, a barrier is arranged between the display unit at the second display region A14 and the first opening, so as to control the organic material at a peripheral position. However, when the thin film encapsulation structures at the second display region A14 and the transition display region A15 are the same as the thin film encapsulation structure at the first display region A13 and the pixel density at each of the second display region A14 and the transition display region A15 is smaller than the first display region A13, a luminous abnormality occurs at the transition display region A15 and the second display region A14, and thereby mixed colors visible to human eyes are produced.

In order to solve the above problems, referring to Fig.6 which is a sectional view of the thin film encapsulation structures at the first display region A13, the second display region A14 and the transition display region of the display substrate, the first thin film encapsulation structure at the first display region A13 includes a first inorganic encapsulation layer 251, a first organic encapsulation layer 252 and a second inorganic encapsulation layer 253 laminated one on another at the light-emitting side of the plurality of display units, the second thin film encapsulation structure includes the first inorganic encapsulation layer 251, the second inorganic encapsulation layer 253 and a second organic encapsulation layer 254 laminated one on another at the light-emitting side of the plurality of display units. The third thin film encapsulation structure includes a first portion 250A and a second portion 250B. The first portion 250A is arranged at a side adjacent to the first display region A13 and the second portion 250B is arranged at a side adjacent to the second display region A14. The first portion 250A includes the first inorganic encapsulation layer 251, the first organic encapsulation layer 252, the second inorganic encapsulation layer 253 and the second organic encapsulation layer 254 laminated one on another at the light-emitting side of the plurality of display units. The second portion 250B includes the first inorganic encapsulation layer 251, the second inorganic encapsulation layer 253 and the second organic encapsulation layer 254 laminated one on another at the light-emitting side of the plurality of display units. A light transmittance of the second organic encapsulation layer 254 is greater than that of the first organic encapsulation layer 252.

Based on the above, the thin film encapsulation layers at the first display region A13, the second display region A14 and the transition display region A15 have different structures. The first organic encapsulation layer 251 and the second inorganic encapsulation layer 253 are formed through PECVD, the first organic encapsulation layer 252 is formed through printing, and the second organic encapsulation layer 254 is formed through coating an OCA. The light transmittance of the second organic encapsulation layer 254 is greater than that of the first organic encapsulation layer 252, so a light transmittance of the first thin film encapsulation structure is smaller than those of the second thin film encapsulation structure and the third thin film encapsulation structure. As a result, it is able to prevent the occurrence of such a phenomenon as luminous abnormality at the transition display region A15 and the second display region A14, thereby to improve the visual experience.

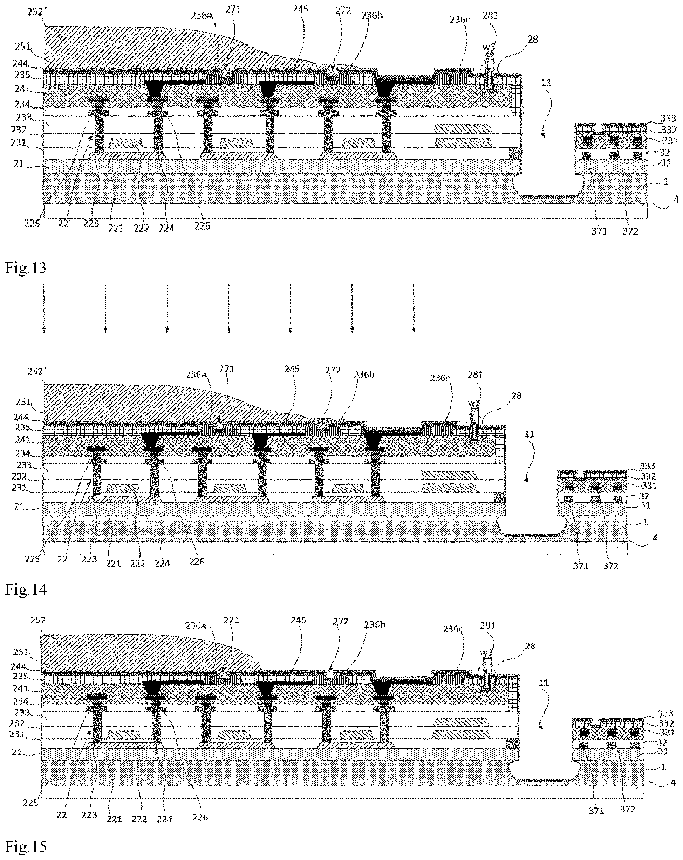

In addition, the first organic encapsulation layer 252 is formed through printing, and the organic material (e.g., organic ink) for forming the first organic encapsulation layer 252 is fluidic, so after the printing, there is a long slope, and the ink is uncontrollable between the first display region A13 and the transition display region A15 (as shown in Fig. 13). Hence, referring to Fig.6, in some embodiments of the present disclosure, a first barrier 271 is arranged between the first display region A13 and the transition display region A15, and a second barrier 272 is arranged between the transition display region A15 and the second display region A14, so as to reduce the risk of the overflow of the organic ink.

Referring to Fig.6, the first barrier 271 is arranged between light-emitting regions of a plurality of display units at the first display region A13 and light-emitting regions of a plurality of display units at the transition display region A15, and the second barrier 271 is arranged between light-emitting regions of a plurality of display units at the second display region A14 and light-emitting regions of a plurality of display units at the transition display region A15.

The first inorganic encapsulation layer 251, the first organic encapsulation layer 252 and the second inorganic encapsulation layer 253 of the first portion 250A are formed by extending the first thin film encapsulation structure to a side where the transition display region A15 is located, the first inorganic encapsulation layer 251, the first organic encapsulation layer 252 and the second inorganic encapsulation layer 253 of the first portion 250A cover the first barrier 271 but do not cover the second barrier 272. In other words, each film layer of the first thin film encapsulation structure at the first display region A13 is made of a same material as the corresponding film layer of the first portion 250A. The first thin film encapsulation structure extends to the transition display region A15 by a certain distance and reaches a position where the first barrier 271 is to be covered but the second barrier 272 is not to be covered, so as to form the first inorganic encapsulation layer 251, the first organic encapsulation layer 252 and the second inorganic encapsulation layer 253 of the first portion 250A.

The second portion 205B is formed by extending the second thin film encapsulation structure to a side where the transition display region A15 is located, and the second portion 205B covers the second barrier 272 but does not cover the first barrier 271.

The second organic encapsulation layer 254 of the first portion 250A is formed by extending the second organic encapsulation layer 254 of the second portion 250B to a side where the transition display region A15 is located. In other words, each film layer of the second thin film encapsulation structure at the second display region A14 is made of a same material as the corresponding film layer of the second portion 250B. The film layers of the second thin film encapsulation structure at the second display region A14 extend to the transition display region A15 by a certain distance to cover the second barrier 272, and the second organic encapsulation layer 254 of the second portion 250B extends to a position where the second inorganic encapsulation layer 253 of the first portion 250A is to be covered.

It should be appreciated that, in the embodiments of the present disclosure, the first barrier 271 is arranged between the first display region A13 and the transition display region A15, and the second barrier 272 is arranged between the second display region A14 and the transition display region A15. In some other embodiments of the present disclosure, the first barrier 271 and the second barrier 272 are arranged at the transition display region A15, orthogonal projections of the first barrier 271 and the second barrier 272 onto the substrate do not coincide with an orthogonal projection of each display unit at the transition display region A15 onto the substrate, the first barrier 271 is arranged at a side of the transition display region A15 adjacent to the first display region A13, and the second barrier 272 is arranged at a side of the transition display region A15 adjacent to the second display region A14.

In addition, referring to Fig.6, because the first organic encapsulation layer 252 is formed through printing and the organic material is fluidic, a slope surface 2520 is formed at a side adjacent to the second display region A14. The second inorganic encapsulation layer 253 covers the first organic encapsulation layer 252, so the first portion 250A is provided with the slope surface 2520 at a side adjacent to the second display region A14, and the second organic encapsulation layer 254 of the first portion 250A covers a side of the slope surface 2520 away from the substrate 1.

Referring to Fig.6, the second organic encapsulation layer 254 of the second thin film encapsulation structure is substantially flush with a surface of the second organic encapsulation layer 254 of the third thin film encapsulation structure away from the substrate.

Referring to Figs.4 and 5, in some embodiments of the present disclosure, the display substrate A is formed on the glass substrate 4, and then stripped off from the glass substrate 4. During the formation of the display substrate, each first opening 11 is formed in such a manner as to penetrate through all film layers at a corresponding position, and films (e.g., the electrode layer and the inorganic encapsulation layers of the display substrate) are formed at positions corresponding to the island regions 13, the bridge regions 12 and the first openings 11.

When stripping the display substrate A off (e.g., through laser lift-off), it is found through research that there are such risks that a film layer between the film layer at the first opening 11 and the film layer at the island region is peeled off and a local film layer is cracked irregularly. In order to reduce this process risk, in Fig.4, the first opening 11 is formed in the display substrate A at a corresponding position in a direction perpendicular to the display substrate, and then the film layers, e.g., the electrode layer and the inorganic encapsulation layers, are formed through evaporation through the whole surface, so as to form these film layers inside the first opening 11.

It should be appreciated that, the first opening 11 is formed through a dry-etching process. Due to the limitation of process conditions, in some embodiments of the present disclosure, the first opening 11 includes an open end 111 arranged at a side away from the substrate 1, a bottom end 112 arranged at a side adjacent to the substrate 1, and an opening body portion 113 arranged between the open end 111 and the bottom end 112. An opening width of at least one of the plurality of first openings 11 is arranged in such a manner that an opening width of the opening body portion 113 gradually increases along the light-emitting direction of the display substrate A, an opening width d1 of the open end 111 is smaller than a maximum opening width d2 of the opening body portion, and the maximum opening width d2 of the opening body portion 113 is greater than an opening width d3 of the bottom end 112, i.e., the first opening has narrower ends and a wider middle portion. At least a part of a side wall of the opening body portion 113 adjacent to the open end 111 is of an arc-like shape.

After verification, based on the above shape of the opening, a wall of the first opening 11 adjacent to the island region 13 and a wall of the first opening 11 adjacent to the bridge region 12 each form a relatively flat surface when peeling the display substrate off through laser lift-off, so it is able to improve the manufacture process. After the peeling, a film layer 15 at the bottom of the first opening 11 is reserved on the glass substrate 4. Here, the flat surface refers to that a surface of the walls of the first opening 11 separated from the film layer 15 is a flat surface, rather than an uneven surface caused when the film layer is peeled off locally or the film layer is cracked irregularly. It should be appreciated that, the opening width of the opening body portion 113 is within a range of 5µm to 25µm, the opening width of the open end 111 is within a range of 3µm to 20µm, and a depth of the opening body portion 113 is within a range of 5µm to 25µm.

In addition, it should be further appreciated that, a difference between the maximum opening width d2 of the opening body potion 113 and the opening width d1 of the open end 111 is within a range of 0.4µm to 4µm. In other words, the opening width of the opening body portion 113 is wider than that of the open end 111 by 0.2µm to 2µm at each of two opposite sides of the first opening 11.

Here, it should be appreciated that, when the thin film encapsulation structure at each of the first display region A13, the second display region A14 and the transition display region A15 is a conventional lamination structure including the first inorganic encapsulation layer 251, the organic encapsulation layer and the second organic encapsulation layer 253, there is a risk that the organic encapsulation layer overflows to the first opening 11. When the first opening 11 is formed in such a manner as to penetrate through all film layers (as shown in Fig.5), there are such risks that a film layer between the film layer at the first opening 11 and the film layer at the island region is peeled off and a local film layer is cracked irregularly.

However, based on the display substrate in the embodiments of the present disclosure, in the second thin film encapsulation structure at the second display region A14, the second organic encapsulation layer 254 is located at an uppermost layer of the encapsulation structure, and it is made of such a material as photoresist. Before peeling off the display substrate, the second organic encapsulation layer 254 is patterned, so as to remove a part of the second organic encapsulation layer 254 at a position corresponding to the first opening. In this way, it is able to reduce the risk that the film layer is peeled off and cracked when peeling off the display substrate.

In addition, referring to Fig.6, in some embodiments of the present disclosure, the display substrate A is formed on the glass substrate 4, and then peeled off from the glass substrate 4. During the formation of the display substrate, a blind hole is formed at a position corresponding to the first opening 11. In other words, a part of the flexible base substrate is reserved. In this way, when peeling off the display substrate through laser lift-off, there is no risk that the film layer is peeled off and cracked. In actual use, whether the first opening 11 is a blind hole or a hole penetrating through all the film layers depends on a stretchable amount of the stretchable substrate.

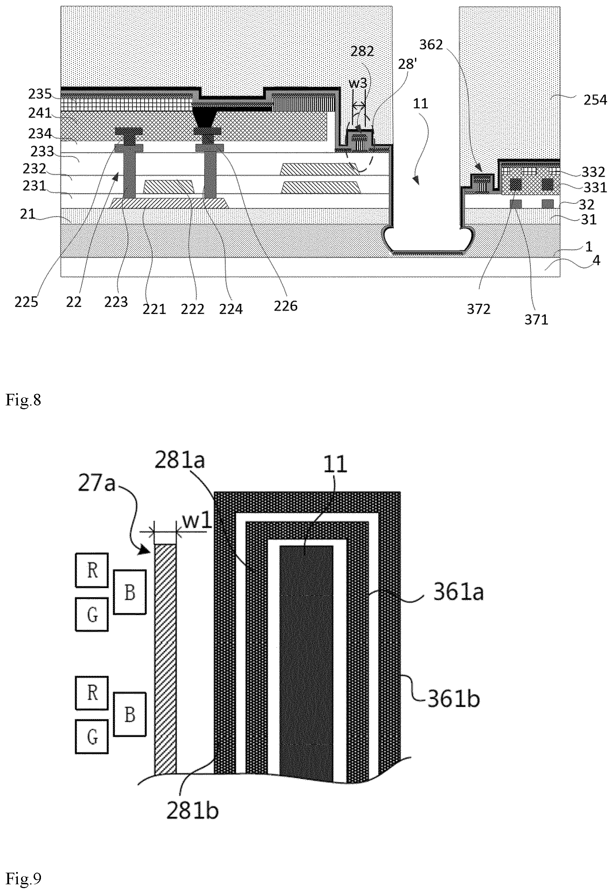

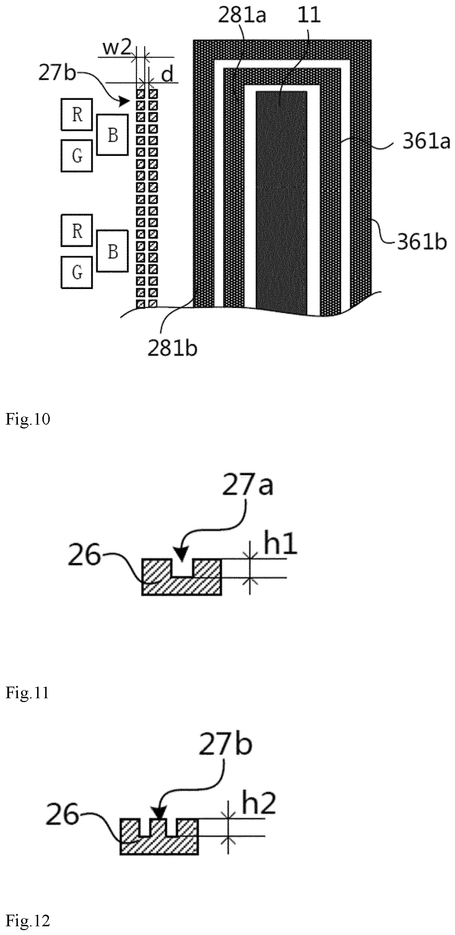

Fig.6 is a schematic view showing the display panel where a part of the display substrate corresponding to the first display region A13, the second display region A14 and the transition display region A15 is formed on the glass substrate. Fig.8 is a schematic view showing the display panel where a part of the display substrate corresponding to the second display region A14 is formed on the glass substrate. Figs.9 and 10 are schematic views showing the arrangement of the island regions, the first openings and the bridge regions of the display panel. Figs. 11 and 12 are sectional views of a first groove in the display panel.

In some embodiments of the present disclosure, a plurality of display units is provided at each of the first display region A13, the second display region A14 and the transition display region A15, and the display units at these display regions have a same structure or different structures.

As shown in Fig.6, at least one of the plurality of display units 2 includes a thin film transistor 22, a first planarization layer 241, a second electrode layer 243, an organic insulation layer 26, a first organic light-emitting layer 245, and a first electrode layer 244. Referring to Fig.6, in some embodiments of the present disclosure, the organic insulation layer includes a plurality of post spacers (PS).

In Figs.6 and 7, the thin film transistor 22 is arranged on the substrate 1, and it includes an active layer 221, a gate electrode 222, a first source electrode 223, a first drain electrode 224, a second source electrode 225, and a second drain electrode 226. The first source electrode 223 and the first drain electrode 224 are electrically coupled to the active layer 221 through a via-hole, and the second source electrode 225 and the second drain electrode 226 are electrically coupled to the first source electrode 223 and the first drain electrode 224 respectively through via-holes. The thin film transistor 22 is not limited to a structure shown in Figs.6 and 7, and in some other embodiments of the present disclosure, it has any other structure, e.g., it includes a source electrode and a drain electrode at a same layer.

The first planarization layer 241 is arranged at the front side of the substrate 1 along the light-emitting direction of the display substrate, i.e., at a side of the substrate 1 adjacent to the cover plate B. To be specific, the first planarization layer 241 is arranged at a side of the thin film transistor 22 away from the substrate 1, and covers the thin film transistor 22. The first planarization layer 241 is configured to provide a flat surface to the film layers formed thereabove.

In some embodiments of the present disclosure, the organic insulation layer 236 is arranged at a side of the first planarization layer 241 away from the stretchable substrate 1, and the first barrier 271 includes a first groove. The first groove is formed in the first planarization layer 241, and the organic insulation layer covers the first groove in a shape-following manner, so as to form the first barrier 271. The second barrier 272 includes a second groove. The second groove is formed in the first planarization layer 241, and the organic insulation layer covers the second groove in a shape-following manner, so as to form the second barrier 272.

In some other embodiments of the present disclosure, the first groove and the second groove are formed in the organic insulation layer, so as to form the first barrier 271 and the second barrier 272.

To be specific, referring to Fig.6, in some embodiments of the present disclosure, the organic insulation layer incudes a first post spacer 236a arranged at the first display region A13, a second post spacer 236b arranged at the transition display region A15, and a third post spacer 236c arranged at the second display region A14, the first groove is formed in the first post spacer 236a, the second groove is formed in the second post spacer 236b, and no groove is formed in the third post spacer 236c.

The second electrode layer 243 is arranged at a side of the first planarization layer 241 away from the stretchable substrate 1, and electrically coupled to the thin film transistor 22 through a via-hole.

The first organic light-emitting layer 245 is arranged at a side of the second electrode layer 243 away from the substrate 1. The first electrode layer 244 is arranged at a side of the first organic light-emitting layer 245 away from the substrate 1 and covers the first organic light-emitting layer 245.

In some embodiments of the present disclosure, the second electrode layer 243 is an anode layer, and the first electrode layer 244 is a cathode layer. The second electrode 243, the first organic light-emitting layer 245 and the first electrode layer 244 together form a light-emitting element driven by the thin film transistor 22. The first organic light-emitting layer 245 is made of different materials so as to form subpixels in different colors.

Referring to Figs.6 and 7, in some embodiments of the present disclosure, the first organic encapsulation layer 252 covers a part of the first inorganic encapsulation layer 251 at a side of the first groove (i.e., the first barrier 271) away from the second groove (i.e., the second barrier 272), and a part of the first inorganic encapsulation layer between the first groove and the second groove and adjacent to the first groove, and does not cover a part of the first inorganic encapsulation layer between the first groove and the second groove and adjacent to the second groove, a part of the first inorganic encapsulation layer at the second groove, and a part of the first inorganic encapsulation layer at a side of the second groove away from the first groove. The second inorganic encapsulation layer 253 covers the first organic encapsulation layer 252 and a part of the first inorganic encapsulation layer 251 not covered by the first organic encapsulation layer 252. The second organic encapsulation layer 254 covers a part of the second inorganic encapsulation layer 253 at the first groove and a part of the second inorganic encapsulation layer 253 at a side of the first groove away from the first display region, and does not over the first openings 11.

The first groove is arranged at a side of a first organic insulation layer 236 away from the substrate 1, and the second groove is arranged at a side of a second organic insulation layer 236 away from the substrate 1, so as to block the overflow of the organic material for forming the first organic encapsulation layer 252. In this way, the first organic encapsulation layer 252 covers a part of the first inorganic encapsulation layer 251 at a side of the first groove away from the second groove, and a part of the first inorganic encapsulation layer 251 between the first groove and the second groove and adjacent to the first groove, and does not cover a part of the first inorganic encapsulation layer 251 between the first groove and the second groove and adjacent to the second groove, a part of the first inorganic encapsulation layer 251 at the second groove, and a part of the first inorganic encapsulation layer 251 at a side of the second groove away from the first groove.

Positions of the first groove and the second groove are determined in accordance with a pitch between the subpixels, and an arrangement mode of the subpixels, at the island regions at the transition display region A15 and the second display region A14.

In Figs.6 and 7, the first groove and the second groove are formed through an exposing and developing process. When the organic material is printed and flows to the second groove, it is difficult for the organic material to continue to overflow to the first opening adjacent to the second groove 27.

Referring to Fig.9, in some embodiments of the present disclosure, each of the first groove and the second groove includes a continuous groove 27a extending in a first direction, and the first direction is an extension direction of a boundary between the first display region and the transition display region, i.e., a length direction of the first opening 11. Referring to Figs.9 and 11, the continuous groove 27a has a groove width w1 of about 5µm to 15µm in a second direction, and a groove height h1 of about 1.0µm to 2.5µm in a third direction. The second direction is perpendicular to the first direction and parallel to the stretchable substrate, and the third direction is perpendicular to the stretchable substrate. In other words, here the groove width w1 refers to a size of the continuous groove 27a in the organic insulation layer 236 in a direction perpendicular to the first direction and parallel to the stretchable substrate 1, and the groove height h1 refers to a size of the continuous groove 27a in the organic insulation layer 236 in a direction perpendicular to the stretchable substrate 1.

Referring to Fig. 10, in some embodiments of the present disclosure, each of the first groove and the second groove includes a least one column of discrete grooves 27b arranged sequentially in a second direction, the second direction is perpendicular to the first direction and parallel to the stretchable substrate, and each column of discrete grooves 27b includes a plurality of discrete grooves 27b spaced apart from each other in the first direction. When each of the first groove and the second groove includes at least two columns of discrete grooves 27b, the at least two columns of discrete grooves 27b are arranged in an array form, i.e., a row direction of the at least two columns of discrete grooves 27b is the second direction, and a column direction is the first direction.

Referring to Figs. 10 and 12, each discrete groove 27b has a groove width w2 of about 5µm to 15µm, and a groove height h2 of about 1.0µm to 2.5µm. Here, the groove width w2 refers to a size of the discrete groove 27b in the organic insulation layer 236 in the second direction, and the groove height h2 refers to a size of the discrete groove 27b in the organic insulation layer 236 in a third direction perpendicular to the stretchable substrate 1.

In Fig. 10, the at least one column discrete grooves 27b includes a plurality of columns (e.g., two columns) of discrete grooves 27b arranged sequentially in the second direction.

A distance d between two adjacent columns of discrete grooves 27b in the plurality of columns of discrete grooves 27b is about 2µm to 15µm. Here, the distance d refers to a distance between the adjacent columns of discrete grooves 27b in the second direction.

It should be appreciated that, in some embodiments of the present disclosure, the first groove has a same shape and a same size as the second groove. In some other embodiments of the present disclosure, the first groove has a shape and a size different from the second groove.

In a process for manufacturing the display panel, some film layers (e.g., the organic light-emitting layer or the electrode layer) are formed through coating at the second display region A14 through the whole surface. Correspondingly, in order to prevent a risk of failure when the film layer corresponding to the first opening is connected to the film layer corresponding to the island region, in some embodiments of the present disclosure, a first isolation structure is arranged between the first groove and the first opening 11 to separate the film layers from each other.

Referring to Figs.6 and 8, in some embodiments of the present disclosure, at least one of the plurality of display units 2 further includes a first isolation structure 28, 28' arranged between the first groove and the first opening 11 and configured to interrupt the first electrode layer at both sides of the first isolation structure 28, 28', so as to increase an active encapsulation distance in a transverse direction. The first electrode layer 244 covers the first isolation structure 28, 28', and is arranged at a side of the first isolation structure 28, 28' adjacent to the first groove and a side of the first isolation structure 28, 28' adjacent to the first opening 11.

Referring to Fig.6, at least one of the plurality of display units 2 further includes a first passivation layer 235. The first passivation layer 235 is arranged between the third post spacer 236c and the first opening 11, and at least a part of the first passivation layer 235 is arranged at a side of the first planarization layer 241 away from the stretchable substrate 1. In addition, at least one of the plurality of display units 2 further includes a first buffer layer 21, a first gate insulation layer 231, a second gate insulation layer 232, an interlayer insulation layer 233, and a second passivation layer 234.

It is found through research that, when the first inorganic encapsulation layer 251 and the second inorganic encapsulation layer 253 are formed through a plasma film-forming process, a lateral film layer formed at a position of the first planarization layer 241 adjacent to the first opening 11 (i.e., a part of the first inorganic encapsulation layer 251 and the second inorganic encapsulation layer 253 on a side wall of the first opening 11) is relatively thin due to a large segment difference. At this time, moisture from the first opening 11 probably enters such elements as the thin film transistor via the thin lateral film layer and the first planarization layer, leading to a failure of the element.

In Figs.6 and 7, the first passivation layer 235 includes a first passivation portion 235a arranged at a side of the first planarization layer 241 away from the stretchable substrate 1 and a second passivation portion 235b arranged at a side of the first planarization layer 241 adjacent to the first opening 11. The second passivation portion 235b is connected to a surface of the second passivation layer 234 so that the first passivation layer 235 protects a surface of the first planarization layer 241 adjacent to the first opening 11 in an isolated manner, thereby it is able to reduce or prevent the moisture from the first opening 11 to enter the elements such as the thin film transistor via the first planarization layer. In some embodiments of the present disclosure, the first passivation layer 235 is made of a same material as the second passivation layer 234, so that the two passivation layers are attached to each other more tightly.

The first buffer layer 21 is arranged at a side of the stretchable substrate 1 adjacent to the first planarization layer 241. The first gate insulation layer 231 is arranged at a side of the first buffer layer 21 away from the stretchable substrate 1, and covers the active layer 221 of the thin film transistor 22. The second gate insulation layer 232 is arranged at a side of the first gate insulation layer 231 away from the stretchable substrate 1, and covers the gate electrode 222 of the thin film transistor 22.

The interlayer insulation layer 233 is arranged at a side of the second gate insulation layer 232 away from the stretchable substrate 1. The second passivation layer 234 is arranged between the interlayer insulation layer 233 and the first planarization layer 241. The first passivation layer 235 is arranged at a side of the first planarization layer 241 away from the stretchable substrate 1, and between the organic insulation layer 236 and the first opening 11.

The gate electrode 222 of the thin film transistor 22 is arranged at a surface of the first gate insulation layer 231 away from the stretchable substrate 1. The first source electrode 223 and the first drain electrode 224 of the thin film transistor 22 are arranged at a surface of the interlayer insulation layer 233 away from the stretchable substrate 1, and electrically coupled to the active layer 221 through via-holes penetrating through the first gate insulation layer 231, the second gate insulation layer 232 and the interlayer insulation layer 233. The second source electrode 225 and the second drain electrode 226 of the thin film transistor 22 are arranged at a surface of the second passivation layer 234 away from the stretchable substrate 1, and electrically coupled to the active layer 221 through via-holes penetrating through the second passivation layer 234. In some other embodiments of the present disclosure, the display unit 2 merely includes the first gate insulation layer 231 rather than the second gate insulation layer 232. In some other embodiments of the present disclosure, the thin film transistor 22 includes a source electrode and a drain electrode at a same layer.

In Figs.6 and 7, the first isolation structure 28 includes at least one third groove 281 formed in the first passivation layer 235, and the first electrode layer 244 covering a bottom of the at least one third groove 281 is separated from the first electrode layer 244 covering the first passivation layer 235. Referring to Figs.6 and 7, the at least one third groove 281 has a groove width w3 of about 3µm to 10µm, and a groove height h3 of about 1000nm to 3000nm. Here, the groove width w3 refers to a size of the third groove 281 in the second direction perpendicular to the first opening 11, and the groove height h3 refers to a size of the third groove 281 in the third direction perpendicular to the stretchable substrate 1.

Referring to Figs.6 and 7, in some embodiments of the present disclosure, at least one of the plurality of wiring units 3 includes a second planarization layer 331, a pixel definition layer 332 and a third electrode layer 333. The second planarization layer 331 is arranged at the front side of the stretchable substrate 1 along the light-emitting direction of the display substrate, i.e., at a side of the stretchable substrate 1 adjacent to the cover plate B. The pixel definition layer 332 is arranged at a side of the second planarization layer 331 away from the stretchable substrate 1, covers a part of a surface of the second planarization layer 331, and has at least one fourth groove 361.

In Fig.6, at least one of the plurality of wiring units 3 further includes a second buffer layer 31, a first conductive wiring 371, a gate insulation layer 32 and a second conductive wiring 372. The second buffer layer 31 is arranged at a surface of the stretchable substrate 1. The first conductive wiring 371 is arranged at a surface of the second buffer layer 31 away from the stretchable substrate 1. The gate insulation layer 32 is arranged at a side of the second buffer layer 31 away from the stretchable substrate 1, and covers the first conductive wiring 371. The second conductive wiring 372 is arranged at a surface of the gate insulation layer 32 away from the stretchable substrate 1.

In Fig.6, the second planarization layer 331 is arranged at a side of the second conductive wiring 372 away from the stretchable substrate 1, and covers the second conductive wiring 372. The at least one fourth groove 361 is arranged adjacent to the first opening 11. The third electrode layer 333 covers a bottom of the at least one fourth groove 361 and a surface of the pixel definition layer 332.

The third electrode layer 333 covering the bottom of the at least one fourth groove 361 is separated from the third electrode layer 333 covering the surface of the pixel definition layer 332, so as to separate the third electrode layer 333 at the bridge region from the third electrode layer 333 corresponding to the first opening 11, thereby to prevent the film layer corresponding to the first opening from being connected to the film layer corresponding to the island region via the film layer corresponding to the bridge region.

As shown in Figs.4 and 5, the display substrate is formed on the glass substrate 4 and then peeled off through laser. Correspondingly, in some embodiments of the present disclosure, corresponding film layers at the first display region A13, the second display region A14 and the transition display region A15 are arranged at a same layer and made of a same material, and corresponding film layers at the island region and the bridge region of the second display region A14 are arranged at a same layer and made of a same material, so as to simplify the manufacture process. The so-called "arranged at a same layer and made of a same material" mentioned herein and hereinafter refers to a situation where film layers with a specific pattern is formed through a single film-forming process, and then patterned through a single patterning process with a same mask to form a layer structure. Depending on different specific patterns, the patterning process includes multiple exposing, developing or etching processes, and the specific pattern in the layer structure is continuous or discontinuous. These specific patterns are arranged at different levels or have different thicknesses.

For example, the second buffer layer 31 is arranged at a same layer, and made of a same material, as the first buffer layer 21. The first conductive wiring 371 is arranged at a same layer, and made of a same material, as parts of the source electrodes and drain electrodes (e.g., the first source electrode 223 and the first drain electrode 224) of the thin film transistor 22. The second conductive wiring 372 is arranged at a same layer, and made of a same material, as parts of the source electrodes and drain electrodes (e.g., the second source electrode 225 and the second drain electrode 226) of the thin film transistor 22. The second planarization layer 331 is arranged at a same layer, and made of a same material, as the first planarization layer 241. The third electrode layer 333 is arranged at a same layer, and made of a same material, as the first electrode layer 244.

Referring to Figs.9 and 10, in some embodiments of the present disclosure, the quantity of fourth grooves 361 in the at least one fourth groove is the same as the quantity of third grooves 281 in the at least one third groove 281, and the at least one fourth groove 361 is connected to the at least one third groove 281 to form a closed loop surrounding the first opening 11. In Figs.9 and 10, the two third grooves 281 (281a and 281b) at a side of the first opening 11 adjacent to the island region are connected to the two fourth grooves 361 (361a and 361b) at a side of the first opening 12 adjacent to the bridge region respectively.

As compared with that in Fig.6, in Fig.8, the first isolation structure 28' includes at least one first protrusion 282 arranged at a surface of the interlayer insulation layer 233 away from the stretchable substrate 1. The first electrode layer 244 covers a top of the at least one first protrusion 282 and the surface of the interlayer insulation layer 233. The first electrode layer 244 at the top of the at least one first protrusion 282 is separated from the first electrode layer 244 at the surface of the interlayer insulation layer 233. Referring to Fig.8, the at least one protrusion has a protrusion width w4 of about 3µm to 10µm, and a protrusion height h4 of about 400nm to 800nm. Here, the protrusion width w4 refers to a size of the first protrusion 282 in the second direction perpendicular to the first opening 11, and the protrusion height h4 refers to a size of the first protrusion 282 in the third direction perpendicular to the stretchable substrate 1. The first protrusion 282 is of a three-layered structure consisting of Ti-Al-Ti.

Correspondingly, referring to Fig.8, in some embodiments of the present disclosure, at least one of the plurality of wiring units 3 includes a gate insulation layer 32, at least one second protrusion 362 and the third electrode layer 333. The gate insulation layer 32 is arranged at the front side of the stretchable substrate 1 along the light-emitting direction of the display substrate, i.e., at a side of the stretchable substrate 1 adjacent to the cover plate B. The at least one second protrusion 362 is arranged at a surface of the gate insulation layer 32 away from the stretchable substrate 1.

In Fig.8, at least one of the plurality of wiring units 3 further includes a second buffer layer 31, a first conductive wiring 371, a second conductive wiring 372, a second planarization layer 331 and a pixel definition layer 332. The second buffer layer 31 is arranged at a surface of the stretchable substrate 1. The first conductive wiring 371 is arranged at a surface of the second buffer layer 31 away from the stretchable substrate 1. A third gate insulation layer 32 is arranged at a side of the second buffer layer 31 away from the stretchable substrate 1, and covers the first conductive wiring 371. The second conductive wiring 372 is arranged at a surface of the third gate insulation layer 32 away from the stretchable substrate 1.

The second planarization layer 331 is arranged at a side of the second conductive wiring 372 away from the stretchable substrate 1, and covers the second conductive wiring 372. The pixel definition layer 332 is arranged at a side of the second planarization layer 331 away from the stretchable substrate 1, and covers a part of the surface of the second planarization layer 331.

The at least one second protrusion 362 is arranged adjacent to the first opening 11. The third electrode layer 333 covers a top of the at least one second protrusion 362 and a part of the third gate insulation layer 32 not covered by the second protrusion 362. The third electrode layer 333 covering the top of the at least one second protrusion 362 is separated from the third electrode layer 333 covering the third gate insulation layer 32, so as to enable the third electrode layer 333 at the bridge region to be separated from the third electrode layer 333 corresponding to the first opening 11, thereby to prevent the film layer corresponding to the first opening to be connected to the film layer corresponding to the island region via the film layer corresponding to the bridge region.

In some embodiments of the present disclosure, corresponding film layers at the island region and the bridge region are arranged at a same layer and made of a same material. For example, the second buffer layer 31 is arranged at a same layer, and made of a same material, as the first buffer layer 21. The first conductive wiring 371 is arranged at a same layer, and made of a same material, as parts of the source electrodes and drain electrodes (e.g., the first source electrode 223 and the first drain electrode 224) of the thin film transistor 22. The second conductive wiring 372 is arranged at a same layer, and made of a same material, as parts of the source electrodes and drain electrodes (e.g., the second source electrode 225 and the second drain electrode 226) of the thin film transistor 22. The second planarization layer 331 is arranged at a same layer, and made of a same material, as the first planarization layer 241. The third electrode layer 333 is arranged at a same layer, and made of a same material, as the first electrode layer 244.

Referring to Figs.9 and 10, in some embodiments of the present disclosure, the quantity of second protrusions 362 in the at least one second protrusion 362 is the same as the quantity of first protrusions 282 in the at least one first protrusion 282, and the at least one second protrusion 362 is connected to the at least one first protrusion 282 to form a closed loop surrounding the first opening 11. The second protrusion 362 and the first protrusion 282 are formed through a single patterning process.

Referring to Figs.6 and 7, in some embodiments of the present disclosure, at each bridge region, the thin film encapsulation structure at a side of the plurality of wiring units 3 away from the stretchable substrate includes the first inorganic encapsulation layer, the second inorganic encapsulation layer 253 and the second organic encapsulation layer 254 laminated one on another at the side of the plurality of wiring units 3 away from the stretchable substrate. The thin film encapsulation structure at the bridge region has a same film layer structure as the thin film encapsulation structure at the island region, and a surface of the second organic encapsulation structure 254 away from the stretchable substrate at the bridge region is flush with a surface of the second organic encapsulation structure 254 away from the stretchable substrate at the island region.

In the case that a requirement on product reliability has been met, any other film layer is not arranged between the second organic encapsulation layer 254 and the cover plate B, so that the display substrate is capable of being flexibly attached to the cover plate at a position corresponding to the bridge region.

The second organic encapsulation layer 254 is formed as follows. At first, an organic material is coated onto the second inorganic encapsulation layer 253, and then a patterning process such as exposing and developing is performed to remove the organic material at a position corresponding to the first opening, so as to acquire the second organic encapsulation layer 254. The organic material for forming the second organic encapsulation layer 254 is 1-methoxy-2-acetoxypropane or acrylic resin.

In some embodiments of the present disclosure, the third electrode layer 333 is arranged at a same layer, and made of a same material, as the first electrode layer 244, so as to simplify the manufacture process.

In addition, an organic encapsulation layer pattern is further arranged at a surface of the second organic encapsulation layer 254 at the bridge region away from the stretchable substrate. The organic encapsulation layer pattern includes at least one second opening, and a length direction of the at least one second opening is parallel to a length direction of the adjacent first opening 11. In some embodiments of the present disclosure, the organic encapsulation layer pattern includes a plurality of second openings parallel to each other. The second openings are formed through an exposing and developing process. Through the second openings in the second organic encapsulation layer 254 at the bridge region, it is able to effectively improve a stretching property of the bridge region.

The display panel in the embodiments of the present disclosure is applicable to various display devices. The present disclosure further provides in some embodiments a display device, including the above-mentioned display panel. The display device is any product or member having a display function, e.g., mobile phone, tablet computer, television, display, laptop computer, digital photo frame or navigator.

Figs. 13 to 16 are schematic views showing some steps of a method for manufacturing a display substrate. The above-mentioned display substrate is capable of being manufactured through the method as shown in Figs. 13 to 16.

As shown in Figs.13 to 16, in some embodiments of the present disclosure, the method for manufacturing the display substrate includes: Step S01 of providing a substrate; and Step S02 of forming a display region on the substrate. The display region includes: a first display region A13 including a plurality of display units arranged on a substrate and a first thin film encapsulation structure arranged at a light-emitting side of the plurality of display units; a second display region A14 including a plurality of display units arranged on the substrate and a second thin film encapsulation structure arranged at a light-emitting side of the plurality of display units; and a transition display region A15 including a plurality of display units arranged on the substrate and a third thin film encapsulation structure arranged at a light-emitting side of the plurality of display units, the transition display region A15 being located between the first display region A13 and the second display region A14. The first thin film encapsulation structure includes a first inorganic encapsulation layer 251, a first organic encapsulation layer 252 and a second inorganic encapsulation layer 253 laminated one on another at the light-emitting side of the plurality of display units. The second thin film encapsulation structure includes the first inorganic encapsulation layer 251, the second inorganic encapsulation layer 253 and a second organic encapsulation layer 254 laminated one on another at the light-emitting side of the plurality of display units. The third thin film encapsulation structure includes a first portion 250A arranged at a side adjacent to the first display region A13 and a second portion 250B arranged at a side adjacent to the second display region A14, the first portion 250A includes the first inorganic encapsulation layer 251, the first organic encapsulation layer 252 and the second inorganic encapsulation layer 253 laminated one on another at the light-emitting side of the plurality of display units, and the second portion 250B includes the first inorganic encapsulation layer 251, the second inorganic encapsulation layer 252 and the second organic encapsulation layer 254 laminated one on another at the light-emitting side of the plurality of display units.

Step S02 specifically includes the following steps.

Step S021: forming a first barrier 271 and a second barrier 272 at the light-emitting side of the plurality of display units at the display region.

To be specific, a first groove and a second groove are formed in an organic insulation layer or a first planarization layer 241 through an exposing and developing process, to serve as the first barrier 271 and the second barrier 272.

Step S022: forming the first inorganic encapsulation layer 251 at the light-emitting side of the plurality of display units at the display region.

To be specific, the first inorganic encapsulation layer 251 is formed through PECVD.

Step S023: printing a first organic material on the first inorganic encapsulation layer 251 to form a first organic material layer, a part of the first organic material layer being located at the first display region A13, and the other part of the first organic material extending to cover the first barrier 271 and/or the second barrier 272.

To be specific, as shown in Fig. 13, the first organic material layer is formed through printing the organic material. The organic material is fluidic, and there is a relatively long slope, so the organic material extends to a position to cover the first barrier 271 but not cover the second barrier 272, or extends to a position to cover the second barrier 272.

Step S024: thinning the first organic material layer to remove a part of the first organic material layer and form the first organic encapsulation layer 252, so as to expose at least a part of the first inorganic encapsulation layer 251 at the transition display region A15.

To be specific, as shown in Fig.14, the first organic material layer is thinned by several hundred angstroms through a plasma thinning process, so as to remove the organic material at the transition display region A15 and expose the first inorganic encapsulation layer 251 at the transition display region A15, thereby to acquire the display substrate as shown in Fig. 15.

Step S025: forming the second inorganic encapsulation layer 253, a part of the second inorganic encapsulation layer 253 covering the first organic encapsulation layer 252, the other part of the second inorganic encapsulation layer 253 covering a part of the first inorganic encapsulation layer 251 not covered by the first organic encapsulation layer 252.

To be specific, the second inorganic encapsulation layer 253 is formed through PECVD.

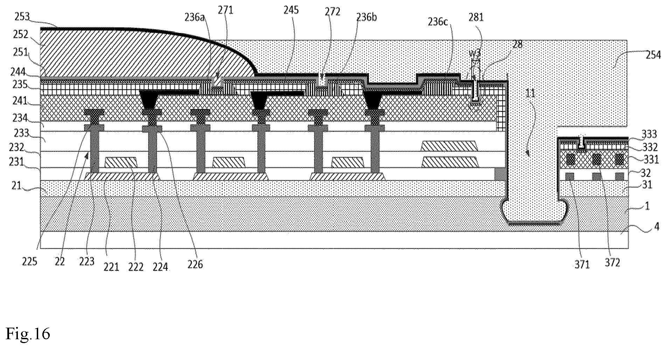

Step S026: as shown in Fig.16, coating the second organic encapsulation layer 254 on the second inorganic encapsulation layer 253, a part of the second organic encapsulation layer 254 covering a part of the second inorganic encapsulation layer 253 covering the first organic encapsulation layer 252, and the other part covering a part of the first inorganic encapsulation layer 251 not covered by the first organic encapsulation layer 252.

To be specific, the second organic encapsulation layer 254 is formed through coating.

It should be further appreciated that, the above embodiments have been described in a progressive manner, and the same or similar contents in the embodiments have not been repeated, i.e., each embodiment has merely focused on the difference from the others. Especially, the product embodiments are substantially similar to the method embodiments, and thus have been described in a simple manner.

The embodiments of the present disclosure have been described hereinabove in details. In order to prevent a concept of the present disclosure from being shielded, some details known in the art are not described. Based on the above description, a person skilled in the art completely knows how to implement the technical solution disclosed herein.

The above embodiments are for illustrative purposes only, but the present disclosure is not limited thereto. Obviously, a person skilled in the art may make further modifications and improvements without departing from the spirit of the present disclosure, and these modifications and improvements shall also fall within the scope of the present disclosure.

## Claims

1. A display substrate, comprising a display region, wherein the display region comprises:
a first display region comprising a plurality of display units arranged on a substrate and a first thin film encapsulation structure arranged at a light-emitting side of the plurality of display units;
a second display region comprising a plurality of display units arranged on the substrate and a second thin film encapsulation structure arranged at a light-emitting side of the plurality of display units; and
a transition display region comprising a plurality of display units arranged on the substrate and a third thin film encapsulation structure arranged at a light-emitting side of the plurality of display units, the transition display region being located between the first display region and the second display region,
wherein the first thin film encapsulation structure comprises a first inorganic encapsulation layer, a first organic encapsulation layer and a second inorganic encapsulation layer laminated one on another at the light-emitting side of the plurality of display units;
the second thin film encapsulation structure comprises the first inorganic encapsulation layer, the second inorganic encapsulation layer and a second organic encapsulation layer laminated one on another at the light-emitting side of the plurality of display units; and
the third thin film encapsulation structure comprises a first portion arranged at a side adjacent to the first display region and a second portion arranged at a side adjacent to the second display region, the first portion comprises the first inorganic encapsulation layer, the first organic encapsulation layer, the second inorganic encapsulation layer and the second organic encapsulation layer laminated one on another at the light-emitting side of the plurality of display units, and the second portion comprises the first inorganic encapsulation layer, the second inorganic encapsulation layer and the second organic encapsulation layer laminated one on another at the light-emitting side of the plurality of display units.

2. The display substrate according to claim 1, wherein the second organic encapsulation layer has a light transmittance greater than the first organic encapsulation layer.

3. The display substrate according to claim 1, wherein the display region comprises a plurality of sides, adjacent sides in the plurality of sides cross to define a plurality of corner portions, and the second display region is located at at least one of the plurality of corner portions.

4. The display substrate according to claim 1, wherein a first barrier is arranged between the first display region and the transition display region, and a second barrier is arranged between the second display region and the transition display region.

5. The display substrate according to claim 1, wherein a first barrier and a second barrier are arranged at the transition display region, orthogonal projections of the first barrier and the second barrier onto the substrate do not coincide with an orthogonal projection of each display unit at the transition display region onto the substrate, the first barrier is arranged at a side of the transition display region adjacent to the first display region, and the second barrier is arranged at a side of the transition display region adjacent to the second display region.

6. The display substrate according to claim 4 or 5, wherein the first inorganic encapsulation layer, the first organic encapsulation layer and the second inorganic encapsulation layer of the first portion are formed by extending the first thin film encapsulation structure to a side where the transition display region is located, the first inorganic encapsulation layer, the first organic encapsulation layer and the second inorganic encapsulation layer of the first portion cover the first barrier,
the second portion is formed by extending the second thin film encapsulation structure to a side where the transition display region is located and covers the second barrier, and
the second organic encapsulation layer of the first portion is formed by extending the second organic encapsulation layer of the second portion to a side where the transition display region is located.

7. The display substrate according to claim 4 or 5, wherein the first organic encapsulation layer of the first portion is provided with a slope surface at a side adjacent to the second display region, and the second organic encapsulation layer of the first portion covers a side of the slope surface away from the substrate.

8. The display substrate according to claim 7, wherein the second organic encapsulation layer of the second thin film encapsulation structure is substantially flush with a surface of the second organic encapsulation layer of the third thin film encapsulation structure away from the substrate.

9. The display substrate according to claim 1, wherein the first display region has a first pixel density, the second display region has a second pixel density, the transition display region has a third pixel density, and each of the second pixel density and the third pixel density is smaller than or equal to the first pixel density.

10. The display substrate according to claim 4 or 5, wherein the second display region comprises:
a stretchable substrate, a plurality of opening patterns being distributed on a surface of the stretchable substrate, each opening pattern in the plurality of opening patterns comprising a plurality of first openings, a plurality of bridge regions being formed between at least a part of adjacent first openings in the plurality of first openings in such a manner as to surround an island region, the plurality of second display units being arranged on the island regions formed by the opening patterns; and
a plurality of wiring units coupled between the display units on the island region and arranged at the plurality of bridge region respectively.

11. The display substrate according to claim 10, wherein at least one of the plurality of display units comprises:
a first planarization layer arranged at a front side of the substrate along a light-emitting direction of the display substrate;
an organic insulation layer arranged at a side of the first planarization layer away from the substrate; and
a first electrode layer arranged at a side of the first planarization layer away from the substrate,
wherein the first barrier comprises a first groove, the first groove is formed in the first planarization layer and the organic insulation layer covers the first groove in a shape-following manner, or the first groove is formed in the organic insulation layer;
the second barrier comprises a second groove, the second groove is formed in the first planarization layer and the organic insulation layer covers the second groove in a shape-following manner, or the second groove is formed in the organic insulation layer;
the first inorganic encapsulation layer is arranged at a side of the first electrode layer away from the substrate and covers the first electrode layer;
the first organic encapsulation layer covers a part of the first inorganic encapsulation layer at a side of the first groove away from the second groove, a part of the first inorganic encapsulation layer at the first groove, and a part of the first inorganic encapsulation layer between the first groove and the second groove and adjacent to the first groove, and does not cover a part of the first inorganic encapsulation layer between the first groove and the second groove and adjacent to the second groove, a part of the first inorganic encapsulation layer at the second groove, and a part of the first inorganic encapsulation layer at a side of the second groove away from the first groove;
the second inorganic encapsulation layer covers the first organic encapsulation layer and a part of the first inorganic encapsulation layer not covered by the first organic encapsulation layer; and
the second organic encapsulation layer covers a part of the second inorganic encapsulation layer at the first groove and a part of the second inorganic encapsulation layer at a side of the first groove away from the first display region, and does not over the first openings.

12. The display substrate according to claim 11, wherein the organic insulation layer comprises a first post spacer arranged at the first display region, a second post spacer arranged at the transition display region, and a third post spacer arranged at the second display region, the first groove is formed in the first post spacer, and the second groove is formed in the second post spacer.

13. The display substrate according to claim 11, wherein each of the first groove and the second groove comprises a continuous groove extending in a first direction, and the first direction is an extension direction of a boundary between the first display region and the transition display region.

14. The display substrate according to claim 13, wherein the continuous groove has a groove width of about 5µm to 15µm in a second direction and a groove height of about 1µm to 2.5µm in a third direction, the second direction is perpendicular to the first direction and parallel to the stretchable substrate, and the third direction is perpendicular to the stretchable substrate.

15. The display substrate according to claim 13, wherein the first groove and/or the second groove comprise a least one column of discrete grooves arranged sequentially in a second direction, the second direction is perpendicular to the first direction and parallel to the stretchable substrate, and each column of discrete grooves comprises a plurality of discrete grooves spaced apart from each other in the first direction.

16. The display substrate according to claim 15, wherein the at least one column of discrete grooves comprises a plurality of columns of discrete grooves, and adjacent columns of discrete grooves are spaced apart from each other by about 2µm to 15µm.

17. The display substrate according to claim 12, wherein at least one of the plurality of display units further comprises:
a first isolation structure arranged between the second groove and the first opening and configured to separate the first electrode layer at both sides of the first isolation structure,
wherein the first electrode layer covers the first isolation structure, and is arranged at a side of the first isolation structure adjacent to the second groove and a side of the first isolation structure adjacent to the first opening.

18. The display substrate according to claim 17, wherein at least one of the plurality of display units at the second display region further comprises:
a first passivation layer, a part of the first passivation layer is arranged between the third post spacer at the second display region and the first opening, and at least a part of the first passivation layer is arranged at a side of the first planarization layer away from the stretchable substrate,
wherein the first isolation structure comprises at least one third groove arranged between the first passivation layer and the first planarization layer, and the first electrode layer covering a bottom of the at least one third groove is separated from the first electrode layer covering the first passivation layer.

19. The display substrate according to claim 18, wherein at least one of the plurality of display units at the second display region further comprises:
a second passivation layer, and at least a part of the second passivation layer is arranged at a side of the first planarization layer adjacent to the stretchable substrate,
wherein the first passivation layer comprises a first portion arranged at a side of the first planarization layer away from the stretchable substrate and a second portion at a side of the first planarization layer adjacent to the first opening, the second portion covers a surface of the first planarization layer adjacent to the first opening, and the second portion is connected to a surface of the second passivation layer so that the first passivation layer protects a surface of the first planarization layer adjacent to the first opening in an isolated manner.

20. The display substrate according to claim 18, wherein at least one of the plurality of display units at the second display region further comprises:
an interlayer insulation layer arranged at the front side of the stretchable substrate along the light-emitting direction of the display substrate,
wherein the first isolation structure comprises at least one first protrusion arranged at a surface of the interlayer insulation layer away from the stretchable substrate, the first electrode layer covers a top of the at least one first protrusion and a part of the surface of the interlayer insulation layer, and the first electrode layer at the top of the at least one first protrusion is separated from the first electrode layer at the surface of the interlayer insulation layer.

21. The display substrate according to claim 20, wherein at least one of the plurality of wiring units comprises:
a second planarization layer arranged at the front side of the stretchable substrate along the light-emitting direction of the display substrate;
a pixel definition layer arranged at a side of the second planarization layer away from the stretchable substrate, covering a part of a surface of the second planarization layer, and having at least one fourth groove; and
a third electrode layer covering a bottom of the at least one fourth groove and a surface of the pixel definition layer,
wherein the third electrode layer covering the bottom of the at least one fourth groove is separated from the third electrode layer covering the surface of the pixel definition layer.

22. The display substrate according to claim 21, wherein the quantity of third grooves in the at least one third groove is the same as the quantity of fourth grooves in the at least one fourth groove, and the at least one fourth groove is connected to the at least one third groove to form a closed loop surrounding the first opening.

23. The display substrate according to claim 22, wherein at least one of the plurality of wiring units comprises:
a gate insulation layer arranged at the front side of the stretchable substrate along the light-emitting direction of the display substrate;
at least one second protrusion arranged at a surface of the gate insulation layer away from the stretchable substrate; and
a third electrode layer covering a top of the at least one second protrusion and a surface of the gate insulation layer not covered by the at least one second protrusion,
wherein the third electrode layer covering the top of the at least one second protrusion is separated from the third electrode layer covering the surface of the gate insulation layer.

24. The display substrate according to claim 23, wherein the quantity of second protrusions in the at least one second protrusion is the same as the quantity of first protrusions in the at least one first protrusion, and the at least one second protrusion is connected to the at least one first protrusion to form a closed loop surrounding the first opening.

25. The display substrate according to claim 10, wherein the first opening comprises an open end arranged at a side away from the substrate, a bottom end arranged at a side adjacent to the substrate, and an opening body portion arranged between the open end and the bottom end, wherein an opening width of at least one of the plurality of first openings is arranged in such a manner that an opening width of the opening body portion gradually increases along the light-emitting direction of the display substrate, an opening width of the open end is smaller than a maximum opening width of the opening body portion, and the maximum opening width of the opening body portion is greater than an opening width of the bottom end.

26. The display substrate according to claim 25, wherein at least a part of a side wall of the opening body portion adjacent to the open end is of an arc-like shape.

27. A display panel, comprising the display substrate according to any one of claims 1 to 26, and a cover plate arranged at a light-exiting side of the display substrate and encapsulated together with the display substrate.

28. A display device, comprising the display panel according to claim 27.

29. A method for manufacturing a display substrate, comprising:
providing a substrate; and
forming a display region on the substrate, wherein the display region comprises: a first display region comprising a plurality of display units arranged on a substrate and a first thin film encapsulation structure arranged at a light-emitting side of the plurality of display units; a second display region comprising a plurality of display units arranged on the substrate and a second thin film encapsulation structure arranged at a light-emitting side of the plurality of display units; and a transition display region comprising a plurality of display units arranged on the substrate and a third thin film encapsulation structure arranged at a light-emitting side of the plurality of display units, the transition display region being located between the first display region and the second display region, wherein the first thin film encapsulation structure comprises a first inorganic encapsulation layer, a first organic encapsulation layer and a second inorganic encapsulation layer laminated one on another at the light-emitting side of the plurality of display units; the second thin film encapsulation structure comprises the first inorganic encapsulation layer, the second inorganic encapsulation layer and a second organic encapsulation layer laminated one on another at the light-emitting side of the plurality of display units; and the third thin film encapsulation structure comprises a first portion arranged at a side adjacent to the first display region and a second portion arranged at a side adjacent to the second display region, the first portion comprises the first inorganic encapsulation layer, the first organic encapsulation layer, and the second inorganic encapsulation layer laminated one on another at the light-emitting side of the plurality of display units, and the second portion comprises the first inorganic encapsulation layer, the second inorganic encapsulation layer and the second organic encapsulation layer laminated one on another at the light-emitting side of the plurality of display units.

30. The method according to claim 29, wherein the forming the display region on the substrate comprises:
forming a first barrier and a second barrier at a light emitting side of the plurality of display units at the display region;
forming the first inorganic encapsulation layer at the light emitting side of the plurality of display units at the display region;
printing a first organic material on the first inorganic encapsulation layer to form a first organic material layer, a part of the first organic material layer being located at the first display region, and the other part of the first organic material extending to cover the first barrier and/or the second barrier;
thinning the first organic material layer to remove a part of the first organic material layer and form the first organic encapsulation layer, so as to expose at least a part of the first inorganic encapsulation layer at the transition display region;
forming the second inorganic encapsulation layer, a part of the second inorganic encapsulation layer covering the first organic encapsulation layer, the other part of the second inorganic encapsulation layer covering a part of the first inorganic encapsulation layer not covered by the first organic encapsulation layer; and
coating the second organic encapsulation layer on the second inorganic encapsulation layer, a part of the second organic encapsulation layer covering a part of the second inorganic encapsulation layer covering the first organic encapsulation layer, and the other part covering a part of the first inorganic encapsulation layer not covered by the first organic encapsulation layer.
